# FASCICULE DE BREVET EUROPEEN

(11) **EP 1 524 700 B1**
(45) Date de publication et mention de la délivrance du brevet: **28.12.2011**
(21) Numéro de dépôt: 04105043.6
(22) Date de dépôt: 14.10.2004
(51) Int. Cl.: H01L 29/74, H01L 29/423, H01L 29/417, H03K 17/722

(54) **Commutateur à commande isolée**
Schalter mit einer isolierten Steuerung
Switch with isolated control

(30) Priorité: 17.10.2003 FR 0350702
(43) Date de publication de la demande: 20.04.2005
(73) Titulaire: STMICROELECTRONICS S.A., 92120 Montrouge (FR)
(72) Inventeur: MENARD, Samuel, 37000, TOURS (FR); MAURIAC, Christophe, 37300 Joue Les Tours (FR)
(74) Mandataire: de Beaumont, Michel

(56) Documents cités:
- EP-A- 0 064 349
- EP-A- 0 312 088
- US-A- 4 760 432

## Description

La présente invention concerne de façon générale des commutateurs de type SCR. On entend par commutateurs de type SCR des composants tels que des thyristors, des triacs et des commutateurs bidirectionnels commandés de divers types et comprenant au moins quatre couches semiconductrices de types de dopage alternés.

La présente invention concerne plus particulièrement l'isolement galvanique d'un circuit de commande d'un commutateur de type SCR.

L'isolement galvanique entre un circuit de commande et un ou plusieurs commutateurs de type SCR commandés est de façon générale réalisé au moyen d'un transformateur ou d'un opto-coupleur. Ces deux moyens d'isolement sont généralement coûteux et difficilement intégrables.

Un objet de la présente invention est de prévoir un commutateur de type SCR monolithique tel que le circuit de commande du commutateur soit isolé galvaniquement du circuit de puissance du commutateur.

Un autre objet de la présente invention est de prévoir un tel commutateur de structure simple.

Pour atteindre ces objets, la présente invention prévoit d'utiliser un commutateur de type SCR commandé en haute fréquence HF et d'intégrer des condensateurs dans la structure.

Plus particulièrement, la présente invention prévoit un commutateur SCR vertical tel que décrit dans la revendication 1.

Selon un mode de réalisation de la présente invention, le commutateur est de type thyristor, comprenant du côté de la face avant une zone semiconductrice principale d'un premier type de dopage formée dans une zone semiconductrice de gâchette d'un second type de dopage, une première portion de la zone principale étant reliée à une des bornes principales, une seconde portion de la zone principale étant reliée à une des bornes de commande par l'intermédiaire d'un premier condensateur intégré, et une portion de la zone de gâchette étant reliée à l'autre des bornes de commande par l'intermédiaire d'un second condensateur intégré.

Selon un mode de réalisation de la présente invention, les première et seconde portions de la zone principale sont deux régions semiconductrices disjointes.

Selon un mode de réalisation de la présente invention, la seconde portion de la zone principale et ladite portion de la zone de gâchette sont recouvertes d'une couche isolante et d'une métallisation, les empilements d'une portion semiconductrice, d'une couche isolante et d'une métallisation constituant lesdits premier et second condensateurs.

Selon un mode de réalisation de la présente invention, la seconde portion de la zone principale et ladite portion de la zone de gâchette sont chacune recouvertes d'une métallisation en contact avec une électrode d'un condensateur intégré dont l'autre électrode est en contact avec une métallisation reliée à une borne principale ou à une borne de commande.

Selon un mode de réalisation de la présente invention, la zone principale est une zone de cathode, la zone principale comprenant une ou plusieurs régions semiconductrices de type N formées dans un caisson de type P constituant la zone de gâchette, le caisson de type P étant formé au-dessus d'une couche semiconductrice de type N sous laquelle est placée une région semiconductrice de type P correspondant à l'anode du thyristor.

Selon un mode de réalisation de la présente invention, la seconde portion de la zone principale correspondant à une région de type N est placée entre ladite première portion de la zone principale correspondant à une région de type N et la portion du caisson de type P reliée à la borne de gâchette.

Selon un mode de réalisation de la présente invention, la première portion de la zone principale comprend plusieurs trous correspondant à des portions du caisson de type P, une métallisation reliée à une borne principale recouvrant la première portion de la zone principale et l'ensemble de ces trous.

Selon un mode de réalisation de la présente invention, le commutateur est de type triac, comprenant du côté de la face avant une zone semiconductrice principale d'un premier type de dopage formée dans un caisson d'un second type de dopage, la zone principale et le caisson étant reliés à une borne principale, une région de gâchette du premier type de dopage étant formée dans le caisson et étant reliée à une borne de commande par l'intermédiaire d'un premier condensateur intégré, et une portion du caisson étant reliée à une borne de référence de gâchette par l'intermédiaire d'un second condensateur intégré.

Selon un mode de réalisation de la présente invention, le commutateur est de type bidirectionnel, comprenant du côté de la face avant une zone semiconductrice principale d'un premier type de dopage formée dans un caisson d'un second type de dopage, la zone principale et le caisson étant reliés à une borne principale, l'ensemble étant entourée d'un mur d'isolement, une région de gâchette du premier type de dopage étant formée dans le mur d'isolement ou dans une prolongation latérale de celui-ci et étant reliée à une borne de commande par l'intermédiaire d'un premier condensateur intégré, et une portion du caisson étant reliée à une borne de référence de gâchette par l'intermédiaire d'un second condensateur intégré.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 est un schéma de commande d'un thyristor faisant partie d'un circuit de puissance ;
la figure 2 est une vue en coupe d'un thyristor ;
la figure 3 est une vue en coupe d'un thyristor selon un mode de réalisation de la présente invention ;
la figure 4 est un exemple de vue de dessus du thyristor de la figure 3 ;
la figure 5 est une vue en coupe d'un thyristor selon un autre mode de réalisation de la présente invention ;
la figure 6 est un exemple de vue de dessus du thyristor de la figure 5 ;
la figure 7 représente un schéma équivalent d'un thyristor selon la présente invention ;
la figure 8 est une vue en coupe d'un commutateur bidirectionnel commandé selon un mode de réalisation de la présente invention ;
la figure 9 est une vue en coupe d'une variante de commutateur bidirectionnel commandé selon un mode de réalisation de la présente invention ;
la figure 10 est une vue en coupe d'un triac selon un mode de réalisation de la présente invention ;
la figure 11 est un exemple de vue de dessus du triac de la figure 10 ; et
la figure 12 représente un schéma équivalent d'un triac selon la présente invention.

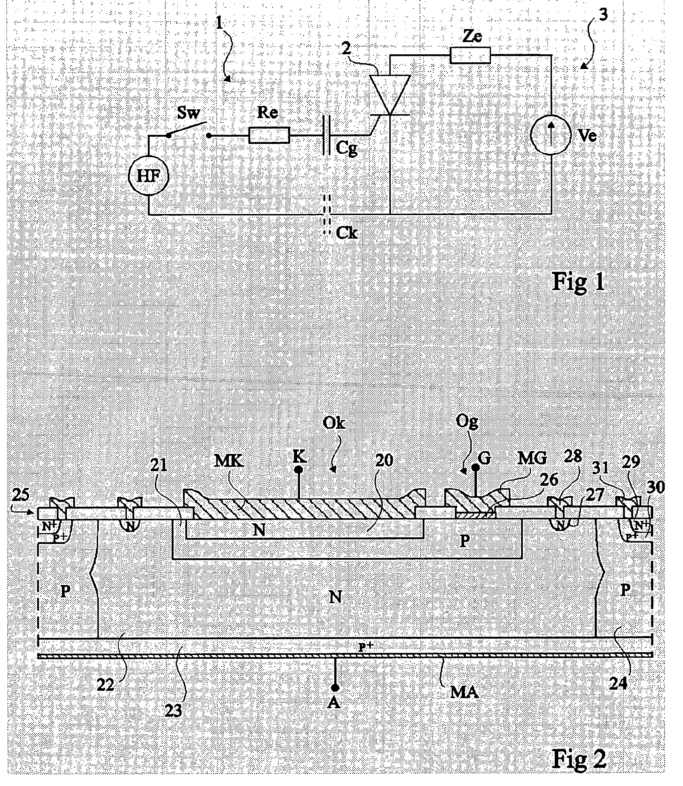

Les figures 2 à 6 et 8 à 11 sont des vues partielles, schématiques et simplifiées et sont uniquement destinées à simplifier la compréhension de la description ci-après. L'homme de l'art saura réaliser des dispositifs pratiques en utilisant des techniques connues. De plus, comme cela est usuel dans le domaine de la représentation des composants semiconducteurs, les dimensions des diverses couches et régions ne sont pas tracées à l'échelle.

Le document EP 0 312 088 décrit un thyristor comprenant des zones semiconductrices reliées à des condensateurs.

La figure 1 est un schéma d'un circuit de commande 1 d'un thyristor 2 inséré dans un circuit de puissance 3. Le circuit de puissance 3 est représenté schématiquement par un générateur de tension V1 et une charge Zl en série entre l'anode et la cathode du thyristor 2. Le circuit de commande 1 est destiné à appliquer un courant entre la gâchette et la cathode du thyristor et comprend essentiellement en série un générateur de tension haute fréquence HF sinusoidale, une résistance de limitation de courant Rlim, un condensateur Cg, et un commutateur Sw. Un tel circuit (sans le condensateur Ck) est décrit dans la demande de brevet français non publiée numéro 0215322 de la demanderesse déposée le 4 décembre 2002 (B5748). En haute fréquence, le condensateur Cg se comporte comme un court-circuit et les variations de tension et de courant sont intégralement transmises au thyristor. Cette demande de brevet expose que, même si l'énergie fournie par le circuit de commande lors de chaque période est inférieure à l'énergie nécessaire pour déclencher le thyristor, celui-ci se déclenche, de façon surprenante, au bout d'un certain nombre de périodes.

La figure 2 est une vue en coupe d'un mode de réalisation d'un thyristor intégrant le condensateur Cg tel que décrit dans la demande de brevet susmentionnée. Le thyristor comprend une région de cathode 20 de type N, formée dans un caisson 21 de type P, lui-même formé dans un substrat 22 faiblement dopé de type N, et une région d'anode 23 de type P du côté de la face arrière du thyristor. Le substrat 22 est entouré d'un mur d'isolement 24 dopé de type P. Le caisson 21 de type P correspond à une zone de gâchette. La face avant du thyristor est recouverte d'une couche isolante 25 dans laquelle sont prévues plusieurs ouvertures dont deux ouvertures Ok et Og respectivement au-dessus de la région de cathode 20 et au-dessus d'une portion du caisson de type P 21. Une métallisation de cathode MK reliée à une borne de cathode K est en contact avec la région de cathode 20 dans l'ouverture Ok. La face arrière du composant est revêtue d'une métallisation d'anode MA reliée à une borne d'anode A. Une couche isolante 26 est placée dans l'ouverture Og de façon à recouvrir une portion du caisson 21. La couche isolante 26 est recouverte d'une métallisation de gâchette Mg reliée à une borne de gâchette G. La zone de gâchette du thyristor est ainsi accessible par l'intermédiaire d'un condensateur dont le diélectrique est la couche isolante 26, les électrodes correspondant à la métallisation Mg et au caisson P 21. Comme cela est décrit dans la demande de brevet susmentionnée, le condensateur Cg n'est pas nécessairement disposé au-dessus de la région de gâchette de cathode.

Un thyristor planar tel que celui représenté en figure 2 comprend couramment du côté de sa face avant une zone annulaire de type N fortement dopée 27, dite d'arrêt de canal, de préférence recouverte d'une métallisation 28 placée dans une ouverture de la couche isolante 25. De plus, une région de type N fortement dopée 29 est couramment formée dans un caisson 30 de type P fortement dopé placé en surface du mur d'isolement 24. Le caisson 30 est recouvert d'une métallisation 31 placée dans une ouverture de la couche isolante 25.

Dans le schéma de la figure 1, la cathode du thyristor 2 est reliée à une borne du circuit de puissance qui sert de référence au circuit de commande. Dans le cas où l'on souhaite que le circuit de commande ait une tension de référence indépendante du circuit de puissance, il faut prévoir un isolement entre les deux circuits.

La présente invention propose, dans le cas d'une commande haute fréquence, d'assurer cet isolement en insérant un condensateur Ck représenté en pointillés sur la figure 1 entre les tensions de référence des circuits de commande et de puissance. L'association d'un circuit de commande produisant un signal de commande haute fréquence et de condensateurs d'isolement sur la gâchette et la cathode du thyristor 2 permet de réaliser de façon simple un isolement galvanique entre le circuit de commande et le thyristor.

La présente invention propose en outre une structure de thyristor intégrant les condensateurs Cg et Ck.

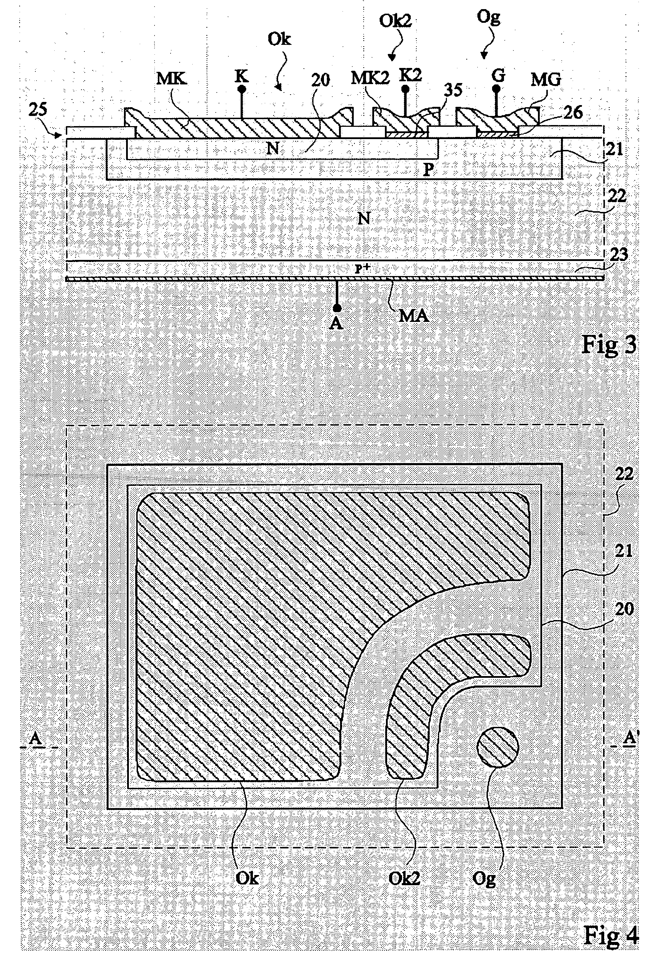

La figure 3 est une vue en coupe d'un mode de réalisation d'un thyristor selon la présente invention intégrant les condensateurs Cg et Ck. L'assemblage des zones semiconductrices et des métallisations du thyristor est similaire à celui du thyristor représenté en figure 2. Les éléments similaires sont désignés par de mêmes références et ne seront pas décrits à nouveau. La différence essentielle est qu'une deuxième ouverture Ok2 distincte de l'ouverture Ok est formée dans la couche isolante 25 au-dessus de la région de cathode 20. L'ouverture Ok2 a une surface nettement inférieure à celle de l'ouverture Ok et est formée à proximité de l'ouverture Og. Une métallisation MK reliée à une borne de cathode K est placée dans l'ouverture Ok et constitue comme précédemment la cathode du circuit de puissance du thyristor. Une couche isolante 35 placée dans l'ouverture Ok2 recouvre une petite portion de la région de cathode 20. Une métallisation MK2 reliée à une borne de cathode auxiliaire K2 recouvre la couche isolante 35. Le thyristor comprend donc deux bornes de cathode. La première borne ou borne principale K est en contact avec la région de cathode et constitue la cathode du circuit de puissance du thyristor. La deuxième borne ou borne auxiliaire K2 est reliée à la région de cathode par l'intermédiaire d'un condensateur Ck dont le diélectrique est la couche isolante 35. La borne auxiliaire K2 constitue une borne de référence de gâchette. L'application d'un signal haute fréquence entre la borne de gâchette G et la borne de référence de gâchette K2 permet d'activer le thyristor. De plus, le générateur du signal haute fréquence est isolé de la partie active du thyristor grâce aux couches isolantes 26 et 35.

La figure 4 est un exemple de vue de dessus du thyristor de la figure 3 sans les métallisations. Les périphéries du caisson P 21 et de la couche N 22 sont sensiblement rectangulaires mais pourraient être circulaires ou de toute autre forme. La région N 20 a une forme de rectangle auquel il manque un coin. L'ouverture Og représentée par un cercle est placée dans le coin "manquant" de la région N 20 au-dessus du caisson 21. L'ouverture Ok2 a une forme de banane autour du coin manquant à proximité de l'ouverture Og. L'ouverture Ok découvre la majorité de la région N 20 non découverte par l'ouverture Ok2. La vue en coupe de la figure 3 est réalisée au niveau du plan AA' représenté en figure 4.

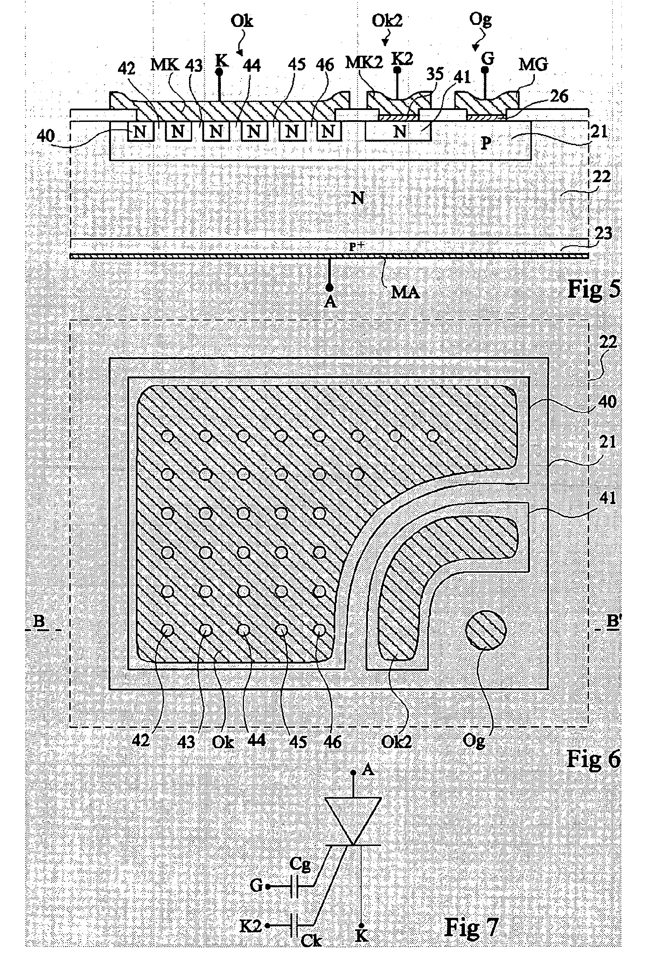

La figure 5 est une vue en coupe d'un thyristor selon une variante de réalisation de la présente invention. Le thyristor représenté est identique à celui de la figure 3 excepté que la région de cathode de type N 20 formée dans le caisson P 21 est remplacée par deux régions N 40 et 41. La région N 40 est formée sous l'ouverture Ok et la région N 41 est formée sous l'ouverture Ok2. La région N 40 comprend de préférence des trous de court-circuit d'émetteur correspondant à des portions 42 à 46 du caisson P 21.

La figure 6 est un exemple de vue de dessus du thyristor de la figure 5. Cette vue de dessus est sensiblement identique à celle de la figure 4 sauf que la région de cathode N 20 est remplacée par deux régions N 40 et 41. La vue en coupe de la figure 5 est réalisée au niveau du plan BB' de la figure 6.

Un avantage du mode de réalisation des figures 5 et 6 est qu'il permet d'optimiser à la fois la sensibilité de déclenchement du thyristor et ses caractéristiques de retournement en dV/dt (retournement provoqué par une variation brutale de la tension entre les bornes principales). En effet, on peut considérer que la région N 41, le caisson P 21, la couche N 22 et la région 23 constituent un thyristor "auxiliaire" très sensible car la région de cathode N 41 est placée à proximité de l'ouverture Og de gâchette et qu'aucun trou de court-circuit n'est prévu dans cette région de cathode. Par contre, la région N 40, le caisson P 21, la couche N 22 et la région 23 constituent un thyristor principal dont la tenue en dV/dt est bonne grâce à la présence de trous d'émetteur. Le déclenchement de ce thyristor principal est provoqué par la mise en conduction du thyristor auxiliaire.

La figure 7 est une représentation schématique d'un thyristor selon la présente invention. La borne de gâchette G permet d'accéder à la zone de gâchette par l'intermédiaire d'un condensateur. De même, une borne de cathode K principale permet d'accéder directement à la zone de cathode du thyristor. Une borne de cathode auxiliaire K2, ou borne de référence de gâchette, permet d'accéder à la zone de cathode du thyristor par l'intermédiaire d'un condensateur. La borne A permet quant à elle d'accéder directement à la zone d'anode du thyristor.

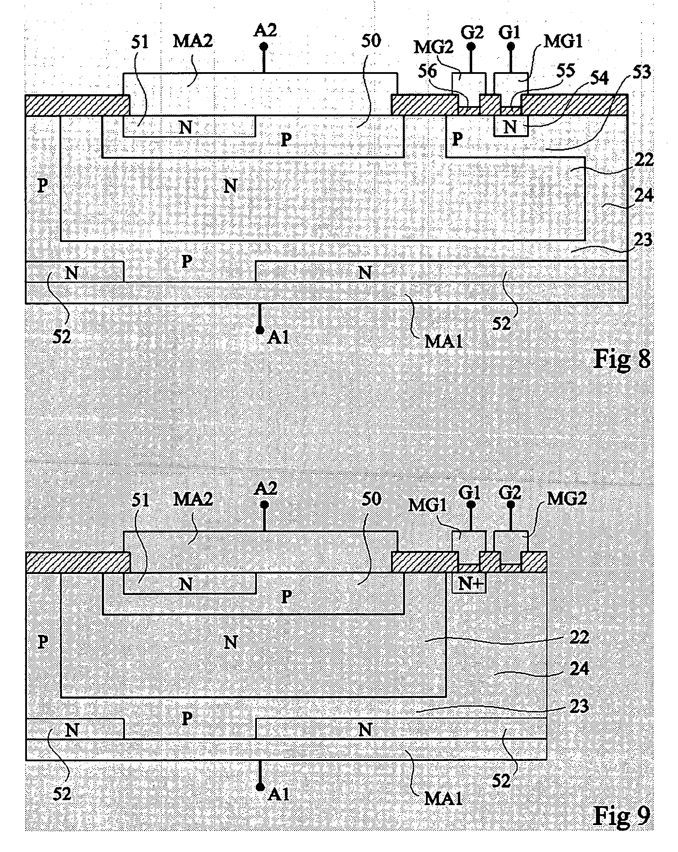

La figure 8 est une vue en coupe d'un commutateur bidirectionnel commandé selon un mode de réalisation de la présente invention. Ce commutateur bidirectionnel est constitué à partir d'un substrat 22 faiblement dopé de type N comprenant du côté de sa face arrière une couche 23 de type P et entouré par un mur 24 de type P. Du côté de la face avant est exposé un caisson 50 de type P dans lequel est formée une région 51 de type N, constituant les deux zones principales de face avant du commutateur. Du côté de la face arrière, une région 52 de type N est formée partout sauf en regard de la région 51 de type N. On trouve ainsi deux composants de type thyristor en antiparallèle respectivement constitués des régions 51-50-22-23 et 50-22-23-52. La zone de déclenchement est formée dans un prolongement 53 vers l'intérieur du mur d'isolement 24. Dans ce prolongement 53 est formée une région de type N 54. Au dessus de la région de type N 54 est formée une métallisation MG1 reliée à une borne de gâchette G1 et au dessus d'une portion de la région 53 est formée une métallisation MG2 reliée à une borne de gâchette G2. Les métallisations MG1 et MG2 sont isolées des régions semiconductrices sous-jacentes par des couches isolantes 55 et 56. Un tel composant se déclenche quand une tension haute fréquence est appliquée entre les bornes G1 et G2.

La figure 9 est une vue en coupe constituant une variante du commutateur bidirectionnel commandé de la figure 8. Dans le cas de la figure 9, au lieu que les régions liées aux bornes G1 et G2 soient formées dans un prolongement vers l'intérieur du mur d'isolement 24, elles sont formées directement dans une partie supérieure de ce mur d'isolement.

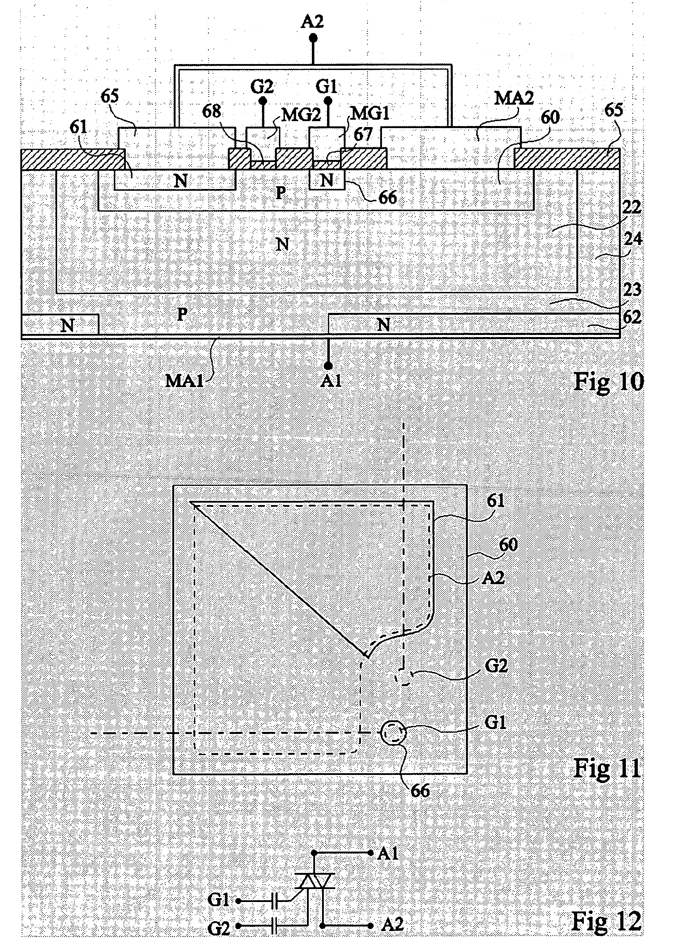

La figure 10 représente un mode de réalisation d'un triac selon la présente invention. Ce triac est constitué à partir d'un substrat faiblement dopé de type N 22 dont la face arrière est revêtue d'une couche 23 de type P et est entourée d'un mur d'isolement de type P 24. Comme dans le mode de réalisation précédent, ce mur d'isolement peut constituer la limite du composant ou peut constituer une limite entre ce composant et un autre composant formé dans le même substrat. Du côté de la face avant est formé un caisson 60 de type P dans lequel est formée une région principale 61 de type N.

Un exemple de forme de ces régions apparaît dans la vue de dessus de la figure 11. Du côté de la face arrière, une couche 62 de type N est formée sensiblement partout sauf en regard de la région 61 de type N du côté de la face supérieure. Une métallisation MA1 reliée à une borne principale A1 revêt la face arrière et une métallisation MA2, en contact avec la région 61 et le caisson 60 est formée dans une ouverture d'une couche isolante 65, cette ouverture étant désignée par la référence A2 en figure 11. Au dessus d'une partie du caisson 60 est formée une région de déclenchement. Cette région est représentée comme étant centrale dans la vue en coupe de la figure 10 et comme étant latérale dans la vue de dessus de la figure 11. La région de déclenchement comprend une région 66 de type N au dessus de laquelle est formée une métallisation MG2, avec interposition d'une couche isolante 67 de façon à former un condensateur entre la métallisation MG2 et la région 66. En outre, une métallisation MG1 est formée au dessus d'une portion du caisson 60 avec interposition d'une région isolante 68. Dans la vue de dessus de la figure 11, les ouvertures correspondantes sont désignées par les régions en pointillés G1 et G2.

La figure 12 est un schéma équivalent du circuit.

Grâce à la commande haute fréquence, les commutateurs bidirectionnels illustrés en figures 8 à 11 peuvent être déclenchés quelle que soit la polarité de la tension appliquée entre les bornes principales A1 et A2.

De façon générale, la présente invention s'applique à tout type de commutateur de type SCR comprenant au moins quatre couches semiconductrices de types de dopage alternés à travers lesquelles un fort courant est susceptible de passer d'une face à une autre entre deux bornes principales et comprenant une borne de gâchette reliée à une zone de gâchette. Un commutateur selon la présente invention comprend en outre une borne de référence de gâchette reliée à une zone de référence de gâchette. Chacune des bornes de gâchette et de référence de gâchette est liée à une zone respective du commutateur par l'intermédiaire d'un condensateur intégré. Le commutateur peut être activé par application d'un signal haute fréquence entre les bornes de gâchette et de référence de gâchette. Le circuit de commande n'est donc pas connecté pour le continu à une borne du circuit de puissance. Ceci présente l'avantage qu'il est toujours possible, si on le souhaite, de connecter la face arrière du composant à la masse, ce qui simplifie un montage de radiateur.

Bien entendu, la présente invention est susceptible de diverses variantes et modifications qui apparaîtront à l'homme de l'art. En particulier, les zones d'un commutateur peuvent être reliées à des bornes par l'intermédiaire d'un condensateur formé au-dessus du commutateur. Les condensateurs peuvent par exemple être constitués entre deux électrodes métalliques, l'une des électrodes étant reliée à une zone du commutateur par un contact conducteur, l'autre électrode étant connectée à une borne du commutateur par un autre contact.

## Revendications

1. Commutateur SCR vertical destiné à être commandé par un signal haute fréquence, comprenant au moins quatre couches principales de types de dopage alternés à travers lesquelles un fort courant est susceptible de passer d'une face à une autre entre deux bornes principales, et comprenant une borne de gâchette reliée à une zone de gâchette par l'intermédiaire d'un condensateur, **caractérisé en ce qu'**il comprend en outre une borne de référence de gâchette reliée par l'intermédiaire d'un condensateur intégré à une zone de référence de gâchette disposée sur la même face du composant que la zone de gâchette, la borne de gâchette et la borne de référence de gâchette étant distinctes des bornes principales et étant adaptées à recevoir entre elles le signal haute fréquence.

2. Commutateur selon la revendication 1 de type thyristor, comprenant du côté de la face avant une zone semiconductrice principale d'un premier type de dopage (20 ; 40, 41) formée dans une zone semiconductrice de gâchette d'un second type de dopage (21), une première portion de la zone principale étant reliée à une des bornes principales (K), une seconde portion de la zone principale étant reliée à la borne de référence de gâchette (K2) par l'intermédiaire d'un premier condensateur intégré (Ck), et une portion de la zone de gâchette (G) étant reliée à la borne de gâchette par l'intermédiaire d'un second condensateur intégré (Cg).

3. Commutateur selon la revendication 2, dans lequel les première et seconde portions de la zone principale sont deux régions semiconductrices disjointes (40, 41).

4. Commutateur selon la revendication 2, dans lequel la seconde portion de la zone principale et ladite portion de la zone de gâchette sont recouvertes d'une couche isolante (26, 35) et d'une métallisation (MG, MK2), les empilements d'une portion semiconductrice, d'une couche isolante et d'une métallisation constituant lesdits premier et second condensateurs.

5. Commutateur selon la revendication 2, dans lequel la seconde portion de la zone principale et ladite portion de la zone de gâchette sont chacune recouvertes d'une métallisation en contact avec une électrode d'un condensateur intégré dont l'autre électrode est en contact avec une métallisation reliée à la borne de référence de gâchette et ou à la borne de gâchette.

6. Commutateur selon la revendication 2, dans lequel la zone principale est une zone de cathode, la zone principale comprenant une ou plusieurs régions semiconductrices de type N (20 ; 40, 41) formées dans un caisson de type P (21) constituant la zone de gâchette, le caisson de type P étant formé au-dessus d'une couche semiconductrice de type N (22) sous laquelle est placée une région semiconductrice de type P (23) correspondant à l'anode du thyristor.

7. Commutateur selon la revendication 6, dans lequel ladite seconde portion de la zone principale correspondant à une région de type N (41) est placée entre ladite première portion de la zone principale correspondant à une région de type N et la portion du caisson de type P reliée à la borne de gâchette.

8. Commutateur selon la revendication 6, dans lequel ladite première portion de la zone principale comprend plusieurs trous correspondant à des portions (42 à 46) du caisson de type P (21), une métallisation (MK) reliée à une borne principale (K) recouvrant la première portion de la zone principale et l'ensemble de ces trous.

9. Commutateur selon la revendication 1 de type triac, comprenant du côté de la face avant une zone semiconductrice principale d'un premier type de dopage (61) formée dans un caisson d'un second type de dopage (60), la zone principale et le caisson étant reliés à une borne principale (A2), une région de gâchette du premier type de dopage (66) étant formée dans le caisson et étant reliée à une borne de gâchette (G1) par l'intermédiaire d'un premier condensateur intégré (Ck), et une portion du caisson étant reliée à une borne de référence de gâchette (G2) par l'intermédiaire d'un second condensateur intégré (Cg).

10. Commutateur selon la revendication 1 de type bidirectionnel, comprenant du côté de la face avant une zone semiconductrice principale d'un premier type de dopage (51) formée dans un caisson d'un second type de dopage (50), la zone principale et le caisson étant reliés à une borne principale (A2), l'ensemble étant entourée d'un mur d'isolement (24), une région de gâchette du premier type de dopage (54) étant formée dans le mur d'isolement ou dans une prolongation latérale de celui-ci et étant reliée à une borne de gâchette (G1) par l'intermédiaire d'un premier condensateur intégré (Ck), et une portion du caisson étant reliée à une borne de référence de gâchette (G2) par l'intermédiaire d'un second condensateur intégré (Cg).

## Claims

1. A vertical SCR switch capable of being controlled by a high-frequency signal, comprising at least four main layers of alternated doping types through which a strong current is capable of circulating from one surface to another between two main terminals, and comprising a gate terminal connected to a gate area via a capacitor, **characterized in that** it further comprises a gate reference terminal connected via an integrated capacitor to a gate reference area arranged on the same surface of the component as the gate area, the gate terminal and the gate reference terminal being different from the main terminals and being adapted to receive between them the high-frequency signal.

2. The switch of claim 1, of thyristor type, comprising on the front surface side a main semiconductor area of a first doping type (20; 40, 41) formed in a gate semiconductor area of a second doping type (21), a first portion of the main area being connected to one of the main terminals (K), a second portion of the main area being connected to one of the gate reference terminal (K2) via a first integrated capacitor (Ck), and a portion of the gate area (G) being connected to the gate terminal via a second integrated capacitor (Cg).

3. The switch of claim 2, wherein the first and second portions of the main area are two separate semiconductor regions (40, 41).

4. The switch of claim 2, wherein the second portion of the main area and said portion of the gate area are covered with an insulating layer (26, 35) and with a metallization (MG, MK2), the stacking of a semiconductor portion, of an insulating portion, and of a metallization forming said first and second capacitors.

5. The switch of claim 2, wherein the second portion of the main area and said portion of the gate area are each covered with a metallization in contact with an electrode of an integrated capacitor having its other electrode in contact with a metallization connected to the gate reference terminal and/or to the gate terminal.

6. The switch of claim 2, wherein the main area is a cathode area, the main area comprising one or several N-type semiconductor regions (20; 40, 41) formed in a P-type well (21) forming the gate area, the P-type well being formed above an N-type semiconductor layer (22) under which is placed a P-type semiconductor region (23) corresponding to the thyristor's anode.

7. The switch of claim 6, wherein the second portion of the main area corresponding to an N-type region (41) is placed between said first portion of the main area corresponding to an N-type region and the portion of the P-type well connected to the gate terminal.

8. The switch of claim 6, wherein the first portion of the main area comprises several holes corresponding to portions (42 to 46) of the P-type well (21), a metallization (MK) connected to a main terminal (K) covering the first portion of the main area and all the holes.

9. The switch of claim 1 of triac type, comprising on the front surface side a main semiconductor area of a first doping type (61) formed in a well of a second doping type (60), the main area and the well being connected to a main terminal (A2), a gate region of the first doping type (66) being formed in the well and being connected to a gate terminal (G1) via a first integrated capacitor (Ck), and a portion of the well being connected to a gate reference terminal (G2) via a second integrated capacitor (Cg).

10. The switch of claim 1 of bi-directional type, comprising on the front surface side a main semiconductor area of a first doping type (51) formed in a well of a second doping type (50), the main area and the well being connected to a main terminal (A2), the assembly being surrounded with an insulating wall (24), a gate region of the first doping type (54) being formed in the insulating wall or in a lateral prolongation thereof and being connected to a gate terminal (G1) via a first integrated capacitor (Ck), and a portion of the well being connected to a gate reference terminal (G2) via a second integrated capacitor (Cg).

## Patentansprüche

1. Ein vertikaler SCR Schalter, der geeignet ist durch ein Hochfrequenzsignal gesteuert zu werden, wobei der Schalter wenigstens vier Hauptlagen von alternierend dotierten Typen aufweist, durch die ein starker Strom von einer Oberfläche zu einer anderen zwischen zwei Hauptanschlüssen zirkulieren kann, und wobei der Schalter einen Gate-Anschluss aufweist, der mit einem Gate-Bereich über einen Kondensator verbunden ist, **dadurch gekennzeichnet, dass** der Schalter ferner einen Gate-Referenzanschluss aufweist, der über einen integrierten Kondensator mit einem Gate-Referenzbereich verbunden ist, der auf der gleichen Oberfläche der Komponente angeordnet ist, wie der Gate-Bereich, wobei der Gate-Anschluss und der Gate-Referenzanschluss unterschiedlich zu den Hauptanschlüssen ist und angepasst ist, um zwischen ihnen das Hochfrequenzsignal zu empfangen.

2. Der Schalter nach Anspruch 1, wobei der Schalter von einem Thyristor Typ ist, und wobei der Schalter auf der Vorderseite einen Haupthalbleiterbereich eines ersten dotierten Typs (20; 40, 41) aufweist, der in einem Gate-Halbleiterbereich eines zweiten dotierten Typs (21) ausgebildet ist, wobei ein erster Teil des Hauptbereichs mit einem der Hauptanschlüsse (K) verbunden ist, wobei ein zweiter Teil des Hauptbereichs mit einem der Gate-Referenzanschlüsse (K2) über einen ersten integrierten Kondensator (Ck) verbunden ist, und wobei ein Teil des Gate-Bereichs (G) mit dem Gate-Anschluss über einen zweiten integrierten Kondensator (Cg) verbunden ist.

3. Der Schalter nach Anspruch 2, wobei der erste und zweite Teil des Hauptbereichs zwei voneinander getrennte Halbleiterbereiche (40, 41) sind.

4. Der Schalter nach Anspruch 2, wobei der zweite Teil des Hauptbereichs und der Teil des Gate-Bereichs mit einer isolierenden Schicht (26, 35) und mit einer Metallisierung (MG, MK2) bedeckt sind, wobei der Stapel eines Halbleiterteils, eines isolierenden Teils und der Metallisierung den ersten und zweiten Kondensator bilden.

5. Der Schalter nach Anspruch 2, wobei der zweite Teil des Hauptbereichs und der Teil des Gate-Bereichs jeweils mit einer Metallisierung bedeckt sind, die in Kontakt ist mit einer Elektrode eines integrierten Kondensators, dessen andere Elektrode in Kontakt ist mit einer Metallisierung, die mit einem der Gate-Referenzanschlüsse und/oder mit dem Gate-Anschluss verbunden ist.

6. Der Schalter nach Anspruch 2, wobei der Hauptbereich ein Kathodenbereich ist, wobei der Hauptbereich einen von mehreren N-Typ Halbleiterbereichen (20; 40, 41) aufweist, die in einer P-Typ Wanne (21) ausgebildet sind, die den Gate-Bereich bilden, wobei die P-Typ Wanne über einer N-Typ Halbleiterschicht (22) ausgebildet ist unter der ein P-Typ Halbleiterbereich (23) angeordnet ist, entsprechend der Anode des Thyristors.

7. Der Schalter nach Anspruch 6, wobei der zweite Teil des Hauptbereichs, der einem N-Typ Bereich (41) entspricht, zwischen dem ersten Teil des Hauptbereichs, der einem N-Typ Bereich entspricht, und dem Teil der P-Typ Wanne, die mit dem Gate-Anschluss verbunden ist, angeordnet ist.

8. Der Schalter nach Anspruch 6, wobei der erste Teil des Hauptbereichs mehrere Löcher aufweist, die Teilen (42 bis 46) der P-Typ Wanne (21) entsprechen, wobei eine Metallisierung (MK), die mit dem Hauptanschluss (K) verbunden ist, den ersten Teil des Hauptbereichs und alle Löcher bedeckt.

9. Der Schalter nach Anspruch 1 eines Triac Typs, wobei der Schalter auf der Vorderseite einen Haupthalbleiterbereich eines ersten dotierten Typs (61) aufweist, der in einer Wanne eines zweiten dotierten Typs (60) ausgebildet ist, wobei der Hauptbereich und die Wanne mit einem Hauptanschluss (A2) verbunden sind, wobei ein Gate-Bereich des ersten dotierten Typs (66) in der Wanne ausgebildet ist und mit einem Gate-Anschluss (G1) über einen ersten integrierten Kondensator (Ck) verbunden ist und ein Teil der Wanne über einen zweiten integrierten Kondensator (Cg) mit einem Gate-Referenzanschluss (G2) verbunden ist.

10. Der Schalter nach Anspruch 1 eines bi-direktionalen Typs, wobei der Schalter auf der Vorderseite einen Haupthalbleiterbereich eines ersten dotierten Typs (51) aufweist, der in einer Wanne eines zweiten dotierten Typs (50) ausgebildet ist, wobei der Hauptbereich und die Wanne mit einem Hauptanschluss (A2) verbunden sind, wobei die Anordnung mit einer isolierenden Wand (24) umgeben ist, wobei ein Gate-Bereich des ersten dotierten Typs (54) in der isolierenden Wand oder in einer setlichen Verlängerung davon ausgebildet ist und mit einem Gate-Anschluss (G1) über einen ersten integrierten Kondensator (Ck) verbunden ist und ein Teil der Wanne über einen zweiten integrierten Kondensator (Cg) mit einem Gate-Referenzanschluss (G2) verbunden ist.
